# EUROPEAN PATENT APPLICATION

(11) **EP 2 667 518 A1**
(43) Date of publication of application: **27.11.2013**
(21) Application number: 13166408.8
(22) Date of filing: 03.05.2013
(51) Int. Cl.: H04B 3/46, G01R 31/04, G01R 31/02

(54) **Receiving apparatus for test signal, electronic apparatus therefor and signal receiving method thereof**

(30) Priority: 24.05.2012 JP 2012118456
(71) Applicant: FUJITSU LIMITED, Kawasaki-shi, Kanagawa 211-8588 (JP)
(72) Inventor: Nakagawa, Keiji, Kanagawa, 211-8588 (JP)
(74) Representative: HOFFMANN EITLE

(57) **Abstract**

A receiving apparatus for a test signal provided on a transmission line in which alternating-current coupling is achieved includes a detection circuit configured to determine whether or not a signal amplitude of the transmission line is more than or equal to a reference value, a control circuit configured to control the detection circuit to be in an active state during a connection test for the transmission line, and a reproduction circuit configured to reproduce a transmission waveform from a transmission apparatus on the transmission line on a basis of a determination result of the signal amplitude in the detection circuit when the signal amplitude changes from a value less than the reference value to a value more than the reference value and further the signal amplitude changes from a value more than the reference value to a value less than the reference value.

## Description

### FIELD

The embodiments relate to a test circuit for a transmission circuit in which alternating-current coupling is achieved.

### BACKGROUND

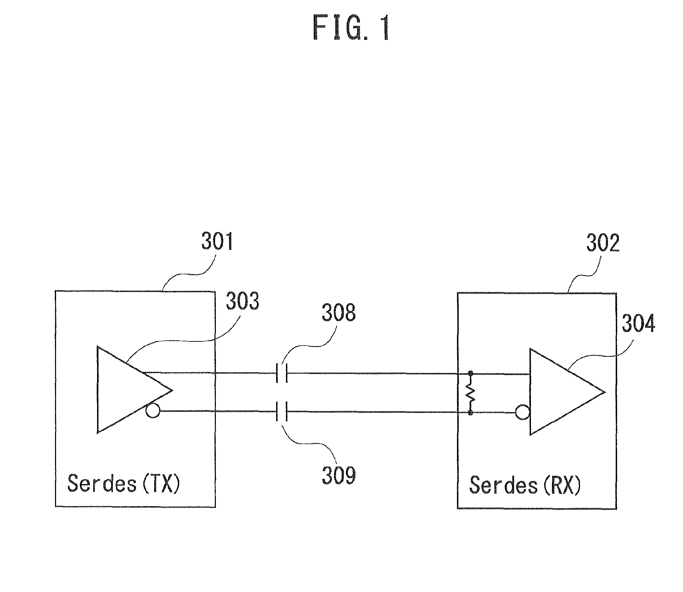

Transmission lines in which alternating-current couplings are achieved have been employed in high-speed serial interfaces in order to achieve the signal acceleration, improve the noise endurance and resolve the direct-current voltage deference and the like. FIG. 1 illustrates a structure of a transmission line in which alternating-current coupling is achieved. In FIG. 1, differential transmission lines are provided between a transmission apparatus 301 and a receiving apparatus 302 as an example of transmission lines in which alternating-current couplings are achieved by condensers 308 and 309. In transmission apparatus 301, a transmission-side transceiver 303 and a parallel-serial conversion unit, which is not depicted, are provided, for example.

In addition, in receiving apparatus 302, a receiving-side receiver 304 and a parallel-serial conversion unit, which is not depicted, are provided, for example. In this structure, for example, parallel digital signals in transmission apparatus 301 are converted into serial signals by the parallel-serial conversion unit and transmitted as differential analog signals from transceiver 303 to the transmission lines. The differential analog signals propagate through the transmission lines in which alternating-current couplings are achieved by condensers 308 and 309 and input into both ends of the input resistance on the receiving apparatus 302 side. Receiver 304 on the receiving apparatus 302 side amplifies the differential analog signals of both ends of the input resistance and transfers the signals to a serial-parallel conversion circuit. The serial-parallel conversion circuit converts the amplified differential analog signals into parallel digital signals. Hereafter, interfaces including a parallel-serial conversion circuit and a serial-parallel conversion circuit are referred to as SerDes (SERializer/DESerializer).

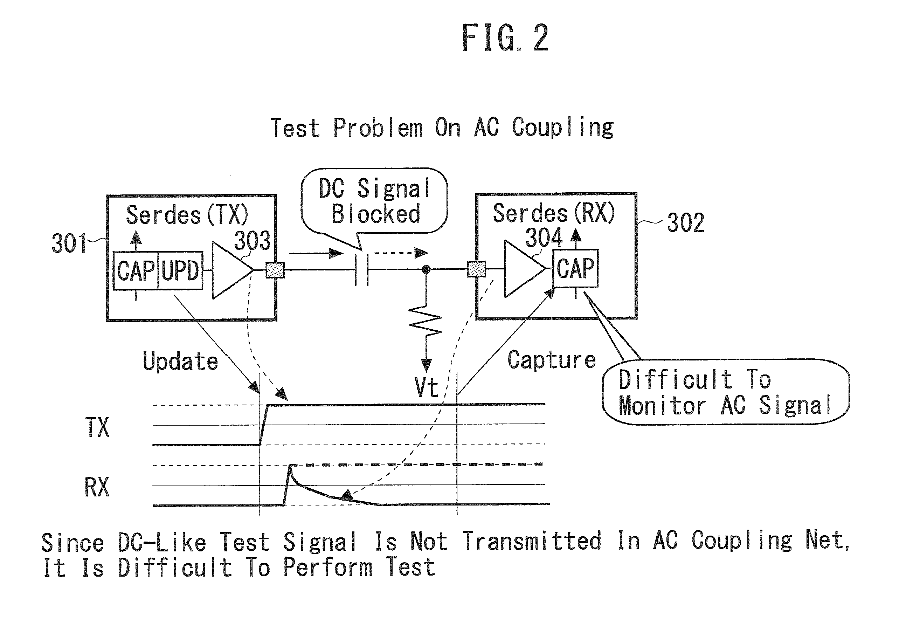

FIG. 2 illustrates a disadvantage which arises when a boundary scan test is performed in a system in which circuit parts are connected via transmission lines in which alternating-current couplings are achieved. FIG. 2 illustrates in a simplified manner elements which operate when boundary scan tests are performed betweentransmission apparatus 301 and receiving apparatus 302 which include high-speed serial interfaces. Transmission apparatus 301 includes a CAP (Capture) circuit for holding bit patterns when boundary scans are performed and a UPD (Update) circuit for outputting the bit patterns in the CAP circuit to transceiver 303.

The bit transmission speeds of boundary scan test signals are lower than the transmission speeds of Serdes. The reason is that, for example, in the boundary scan tests low speed clocks are used in order to reliably detect the connection conditions between plural types of circuit parts. Therefore, even when boundary scan test signals are transmitted to transmission lines in which alternating-current couplings are achieved by condensers provided for high-speed transmission, the direct-current components are dominant for the condensers forhigh-speed transmission. Thus, it is difficult for receiver circuits of Serdes to receive the test signals via the transmission lines in which alternating-current couplings are achieved by condensers for high-speed transmission. Since, as illustrated in FIG. 2, condensers block signals whose speeds are lower than the direct-current components or the transmission bands of the alternating-current couplings.

For example, the low speed clock signals function like step input signals for condensers for high-speed transmission. As a result, signals passed through the condenser are signals which fall from the peak on the spike based on the time constant of the transmission line. When the time constant is shorter than the cycle of the clock signal, that is, the speed of the clock signal is lower than the transmission band of the transmission line, receiver 304 and the CPA circuit on the receiving apparatus 302 side do not receive boundary scan test signals from the alternating-current coupling transmission line.

Therefore, the conventional test specification IEE 1149.6 specifies that, aside from a receiver circuit for serial data, a test receiver circuit (hereafter, referred to as test receiver) which may detect boundary scan test signals via alternating-current coupling receives the test signals and the outputs from the test receiver circuit are retrieved to detect faults.

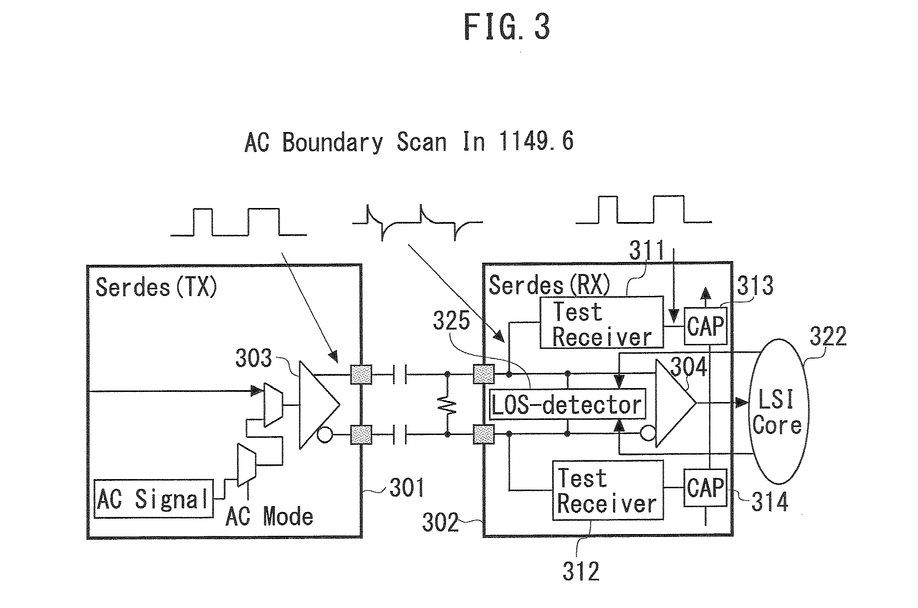

FIG. 3 illustrates a structure of a boundary scan test circuit in accordance with IEEE 1149.6. In the boundary scan test circuit in FIG. 3, transmission apparatus 301 uses an alternating-current mode (AC Mode) selection signal to select an alternating-current signal (AC signal) by a selector and sends the AC signal to transceiver 303. That is, in this structure, similar to the case in FIG. 2, transmission apparatus 301 transmits AC signals via transceiver 303. Receiving apparatus 302 includes test receivers 311 and 312. Test receivers 311 and 312 reproduce signals with a spike-like peak into square waves and send the square waves to CAP circuits 313 and 314. As a result, CAP circuits 313 and 314 in receiving apparatus 302 may retrieve boundary scan signals.

In addition, as illustrated in FIG. 3, general Serdes includes a detection circuit (LOS-detector) 325 for detecting the voltage difference between differential signals in receiving apparatus 302. LOS-detector 325 is a circuit for detecting whether or not receiver 304 of Serdes maintains a voltage enough to discriminate differential signals. LOS-detector 325 is installed in order to determine whether or not serial data reaches at receiving apparatus 302 in the normal operation. However, the determination results in LOS-detector 325 are not referred during the boundary scan tests. Further, since LSI core 322 halts during the boundary scan tests, LOS-detector 325 is not controlled so that the performance is not ensured.
[Patent document 1]
Japanese Laid-Open Patent Publication No. 2005-57677

### SUMMARY

However, in the conventional techniques as described above, a test receiver dedicated for the test is connected with an input terminal for a transmission line. When a circuit other than the receiver which is inherently provided for signal transmission is additionally connected with the input terminal for the transmission line, it leads to the deterioration of the return loss caused by the increase of input capacitance and the decrease in transmission performance.

It is an object of the embodiments that connection tests using test signals whose speeds are lower than the transmission bands of transmission lines may be achieved without additionally implementing a structure such as a test receiver in the alternating-current coupling transmission line.

An aspect of the embodiments exemplifies a receiving apparatus for a test signal provided on a transmission line in which alternating-current coupling is achieved. The receiving apparatus includes a detection circuit configured to determine whether or not a signal amplitude of the transmission line is more than or equal to a reference value, a control circuit configured to control the detection circuit to be in an active state during a connection test for the transmission line, and a reproduction circuit configured to reproduce a transmission waveform from a transmission apparatus on the transmission line on a basis of a determination result of the signal amplitude in the detection circuit when the signal amplitude changes from a value less than the reference value to a value more than the reference value and further the signal amplitude changes from a value more than the reference value to a value less than the reference value.

### BRIEF DESCRIPTION OF THE DRAWINGS

FIG. 1 is a diagram illustrating a structure of a transmission line in which alternating-current coupling is achieved.
FIG. 2 is a diagram illustrating disadvantage which arises when a boundary scan test is performed in a system in which circuit parts are connected via transmission lines in which alternating-current couplings are achieved.
FIG. 3 is a diagram illustrating a structure of a boundary test circuit.
FIG. 4 is a diagram illustrating a structure of a test circuit in embodiment 1.
FIG. 5A is a diagram illustrating a structure of a conventional receiving apparatus.
FIG. 5B is a diagram illustrating a structure of a receiving apparatus in embodiment 1.
FIG. 6A is a diagram illustrating a connection between a conventional LOS-detector and an LSI core logic.
FIG. 6B is a diagram illustrating connections between a LOS-detector, a control circuit and an LSI core logic in embodiment 1.
FIG. 7A is a diagram illustrating a conventional receiving circuit.
FIG. 7B is a diagram illustrating a structure of a sampling circuit.
FIG. 8 is a diagram illustrating a structure of a LOS-detector.
FIG. 9 is a diagram illustrating a timing chart of signal waveforms.
FIG. 10 is a diagram illustrating signals in case of an open fault.
FIG. 11 is a diagram illustrating signals in case of a short fault.
FIG. 12 is a diagram illustrating signals in case of a short between differential signals.
FIG. 13A is a diagram illustrating a structure for setting conventional test conditions.
FIG. 13B is a diagram illustrating a structure of a control circuit in embodiment 2.

### DESCRIPTION OF EMBODIMENTS

Hereafter, a receiving apparatus according to one aspect of the embodiments is described below with reference to the drawings. The structure in the embodiment as described below is an example and the apparatus is not limited to the structure of the embodiment.

### [Embodiment 1]

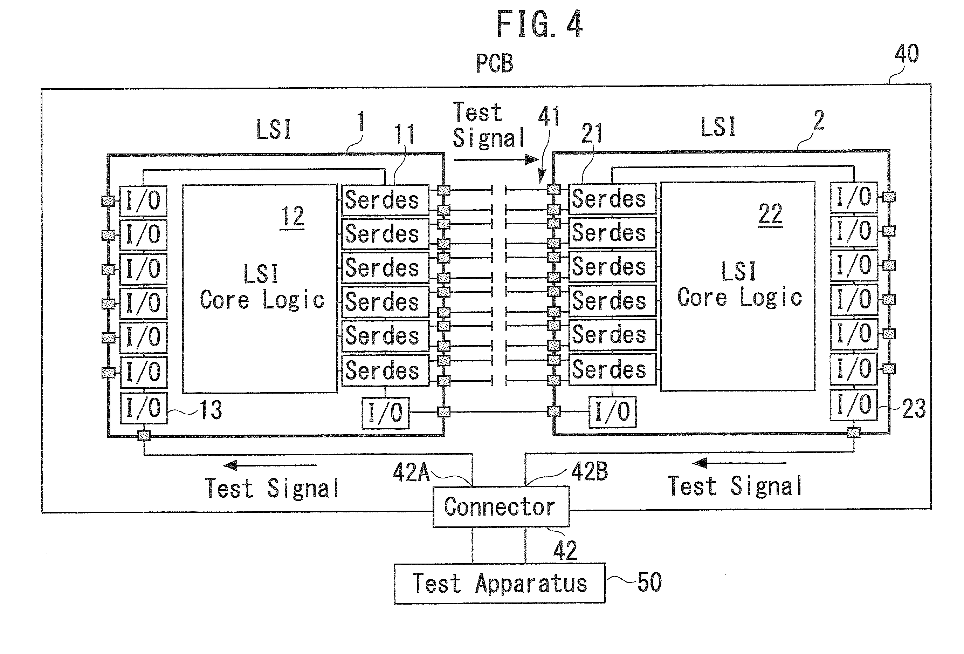

FIG. 4 illustrates a structure of a test circuit for performing boundary scan tests. The test circuit includes a printed-circuit board 40 as the test subject and a test apparatus 50 which is connected with a connector 42 of printed-circuit board 40. The example in FIG. 4 illustrates an integrated circuit 1 as the transmission side and an integrated circuit 2 as the receiving side.

Integrated circuit 1 includes input-output circuits 13, SerDes (hereafter, transmission circuits 11) which are connected with input-output circuits 13 and an LSI core logic 12. For example, after tests such as boundary scan tests are performed in a factory or after the factory shipment, in the normal operation conditions of printed-circuit board 40, LSI core logic 12 communicates with other parts on printed-circuit board 40 through interfaces such as SerDes. However, LSI core logic 12 of integrated circuit 1 halts during the boundary scan tests.

As illustrated in FIG. 4, integrated circuit 1 connects one or more input-output circuits 13 with one or more transmission circuits 11 via a chain of serial signal lines. When the boundary scan tests are performed, transmission circuits 11 transmit test signals to receiving circuits 21 on integrated circuit 2. The structure of transmission circuit 11 is the same as the structure of transmission circuit 301 in FIG. 2, for example. Transmission circuit 11 includes a CAP (Capture) circuit for holding bit patterns during the boundary scan tests and a UPD (Update) circuit for outputting the bit patterns of the CPA circuit to a transceiver. Transmission circuit 11 is an example of the transmission apparatus.

Input-output circuit 13 is, for example, an interface circuit such as I2C (Inter-Integrated Circuit) and PCI (Peripheral Component Interconnect), which are input-output circuits other than SerDes. However, the structure of integrated circuit 1 is not limited to the one illustrated in FIG. 4. For example, integrated circuit 1 does not include input-output circuits 13. In addition, input-output circuits 13 may be used instead of transmission circuits 11 (SerDes) to perform the boundary tests between integrated circuit 1 and integrated circuit 2.

Integrated circuit 2 connects one or more input-output circuits 23 and one or more receiving circuits 21 via a chain of serial signal lines. Here, receiving circuit 21 is illustrated as SerDes as well as transmission circuit 11 in integrated circuit 1 and is an input-output circuit which includes a conversion function between parallel signals and serial signals. That is, the structure of receiving circuit 21 is the same as the one of receiving apparatus 302 in FIG. 2, for example. Receiving circuit 21 includes a receiver on the receiving side and a parallel-serial conversion circuit. In addition, input-output circuit 23 is the same as input-output circuit 13 in integrated circuit 1. Further, integrated circuit 2 includes LSI core logic 22 which is connected with receiving circuits 21. Similar to LSI core logic 12, LSI core logic 22 also halts during the boundary scan tests.

Transmission circuits 11 in integrated circuit 1 and receiving circuits 21 in integrated circuit 2 are connected via transmission lines 41 in which alternating-current couplings are achieved by condensers. In embodiment 1, transmission circuits 11 transmit differential signals to transmission lines 41, and receiving circuits 21 receive the differential signals from transmission lines 41. Thus, in embodiment 1, transmission lines 41 are transmission lines for differential signals.

Connector 42 includes an output port 42A for outputting signals from test apparatus 50 to printed-circuit board 40 and an input port 42B for inputting signals from printed-circuit board 40 to test apparatus 50. Output port 42A is connected with input-output circuits 13 and transmission circuits 11 in integrated circuit 1 via a chain of serial signal lines. And, test control signals from test apparatus 50 are transmitted to input-output circuits 13 and transmission circuits 11 through the chain of serial signal lines. Here, test control signals includes bit patterns of test signals during the boundary scan tests and test-mode signals which are set in transmission circuits 11 during the boundary scan tests. In addition, input port 42B is connected with input-output circuits 23 and transmission circuits 21 in integrated circuits 2 via a chain of serial signal lines. And, the receiving results of boundary test signals from integrated circuit 1 which are received by receiving circuits 21 in integrated circuit 2 are input into input port 42B of connector 42 via the chain f signal lines.

Test apparatus 50 transmits a variety of bit string signal waveforms to printed-circuit board 40 through output port 42A of connector 42. In addition, test apparatus 50 transmits configuration signals for controlling the boundary scan tests between transmission circuits 11 and receiving circuits 21 to printed-circuit board 40. Test apparatus 50 may pass the bit string signal waveforms and configuration signals to input-output circuits 13 and transmission circuits 11 via the chain of serial signal lines on connector 42 and printed-circuit board 40.

Transmission circuits 11 in integrated circuit 1 acquire the signal waveforms sent from test apparatus 50 by the CPA circuits in transmission circuits 11, convert the signal waveforms to bit strings, and store the bit strings in a memory or a buffer, which is not depicted. The UPD circuits in transmission circuits 11 use the bit strings acquired by the CAP circuits to generate transmission digital signals, and then convert the transmission digital signals to test signals which are differential analog and transmit the test signals to transmission lines 41 through a transceiver.

Receiving circuits 21 in integrated circuit 2 input the differential analog signals received through transmission lines 41 into the CPA circuits. The CAP circuits use the input differential analog signals to generate bit strings. Receiving circuits 21 pass the bit strings generated by the CAP circuits to test apparatus 50 via connector 42. Receiving circuit 21 is an example of the receiving apparatus.

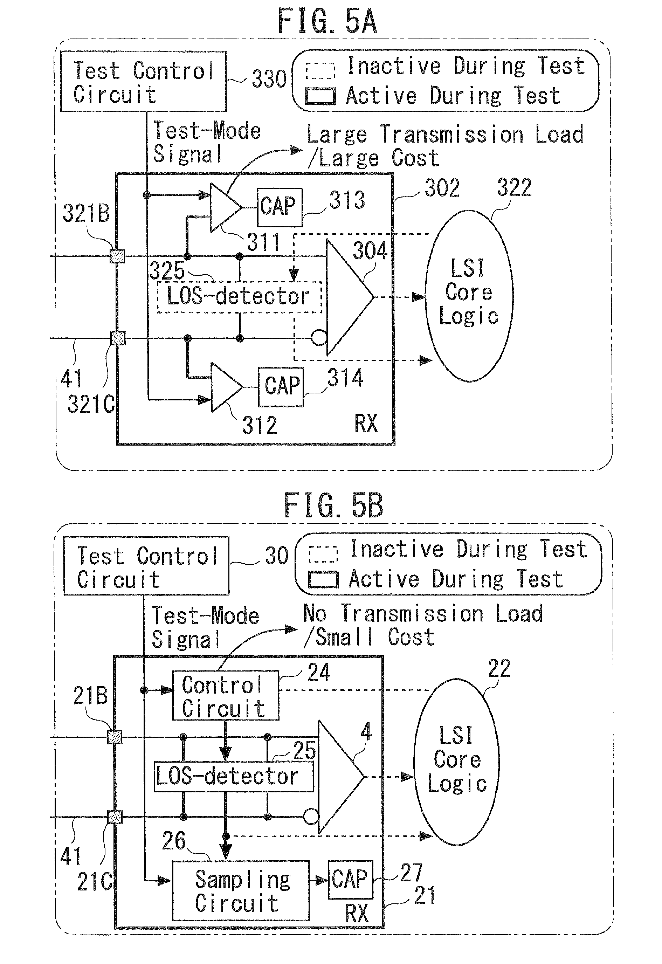

FIG. 5A illustrates the structure of conventional receiving apparatus 302. The structure of receiving apparatus 302 is the same as the case in FIG. 3. Thus, in the structure of receiving apparatus 302, the elements which are the same as those illustrated in FIG. 3 are represented with the same symbols and the explanations thereof are omitted. However, FIG. 5A illustrates input ports 321B and 321C for inputting test signals from transmission lines 41 into receiving apparatus 302 and a test control circuit 330 for controlling whether or not receiving apparatus 302 performs the boundary scan tests. As for transmission lines 41 in FIG. 5A, the signal line connected with input port 321B is referred to as the positive-side signal line. In addition, as for transmission lines 41, the signal line connected with input port 321C is referred to as the negative-side signal line.

Test control circuit 330, for example, includes a test-mode register which is set on or off by control signals from test apparatus 50. The test-mode register controls according to the set value whether or not receiving apparatus 302 performs the boundary scan tests.

Inaddition, in conventional receiving apparatus 302, LSI core logic 22, LOS-detector 325 and receiver 304 are inactive during the boundary scan tests. The term "inactive" means a state in which an enable terminal is not asserted or a state in which the power supply is not turned on.

FIG. 5B illustrates a structure of receiving circuit 21 in embodiment 1. Similar to conventional receiving apparatus 302, receiving circuit 21 includes a receiver 4, an LSI core logic 22 and a LOS-detector 25. In addition, receiving circuit 21 includes a control circuit 24 for controlling the operation state of LOS-detector 25, a sampling circuit 26 for sampling detection signals from LOS-detector 25 and a CAP circuit 27 for converting the signals sampled by sampling circuit 26 into bit strings and storing the bit strings in a memory.

Further, FIG. 5B illustrates input ports 21B and 21C for inputting test signals from transmission lines 41 into integrated circuit 2 and a test control circuit 30 for controlling whether or not receiving circuit 21 performs the boundary scan tests. Input ports 21B and 21C and test control circuit 30 are the same as input ports 321B and 321C and test control circuit 330 in FIG. 5A. That is, in FIG. 5B, one ends of transmission lines 41 in which alternative-current couplings are achieved are connected with input ports 21B and 21C of receiving circuit 21. And, input ports 21B and 21C are connected with receiver 4 in receiving circuit 21. However, receiver 4 is inactive during the boundary scan tests as described above. Further, input ports 21B and 21C are connected with LOS-detector 25 for detecting signal amplitudes between input ports 21B and 21C. LOS-detector 25 is an example of the detection circuit.

In embodiment 1, test apparatus 50 sends test-mode signals during the boundary scan tests. The test-mode signals set control circuit 24 in test mode. Control circuit 24 turns LOS-detector 25 into an active state according to the test mode which is set by test apparatus 50. Thus, during the boundary scan tests, LOS-detector 25 detects signal amplitudes between input ports 21B and 21C and determines the presence or absence of differential signals on transmission lines 41.

Sampling circuit 26 acquires the determination results in LOS-detector 25 as two-valued pulses of HI (high potential) and LO (low potential). Sampling circuit 26 reproduces based on the determination results in LOS-detector 25 signal waveforms transmitted to transmission lines 41 in which alternating-current couplings are achieved. CAP circuit 27 generates bit strings based on the reproduced signal waveforms and stores the bit strings in the memory. The bit strings in the memory are passed to test apparatus 50 via the chain of serial signal lines during a predetermined time period according to the control of test apparatus 50. Sampling circuit 26 is an example of the reproduction circuit.

In receiving circuit 21 in FIG. 5B, a circuit which is used for the boundary scan tests such as test receivers 311 and 312 in receiving apparatus 302 in FIG. 5A is not connected with transmission lines 41. For example, sampling circuit 26 and CAP circuit 2 7 added in FIG. 5B are connected with LOS-detector 25. Therefore, according to the structure of receiving circuit 21 in FIG. 5B, since a circuit for the boundary scan tests is not connected with input ports 21B and 21C, the fluctuation of input impedance and the increase of input capacitance in receiving circuit 21 which are seen from transmission lines 41 are suppressed.

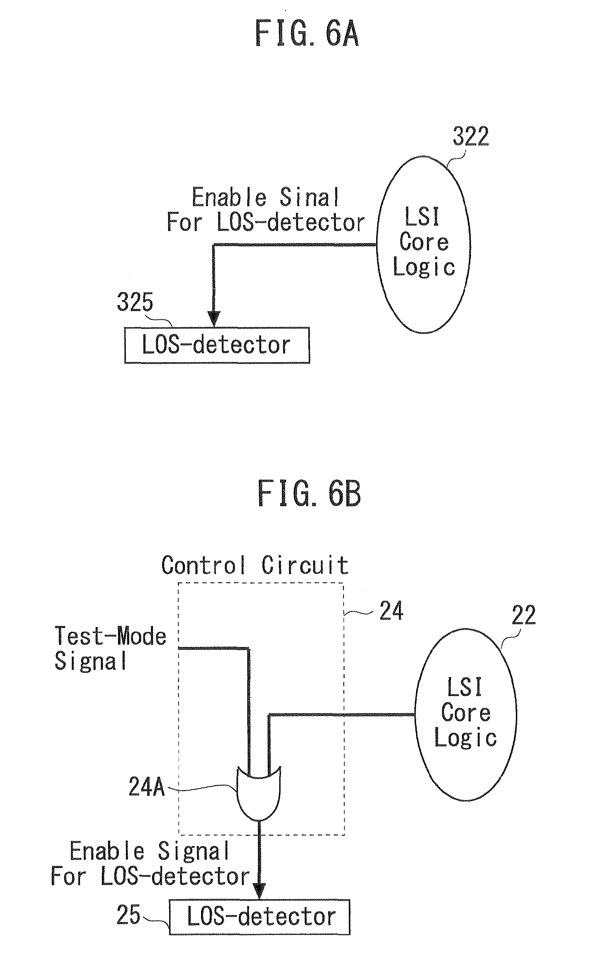

FIG. 6A illustrates a connection between conventional LOS-detector 325 and LSI core logic 322. The operation states of conventional LOS-detector 325 are controlled by enable signals from LSI core logic 322.

FIG. 6B illustrates connections between LOS-detector 25, control circuit 24 and LSI core logic 22 in embodiment 1. Control circuit 24 includes an OR gate 24A. OR gate 24A outputs a logical sum of a test-mode signal from test control circuit 30 and an enable signal from LSI core logic 22 as an enable signal of LOS-detector 25. Therefore, even when LSI core logic 22 disables (turns into an inactive state) enable signals, test control circuit 30 may enable, that is, turn LOS-detector 25 into an active state by the test-mode signals. Namely, test apparatus 50 may enable LOS-detector 25 by setting test-mode signals in test control circuit 30.

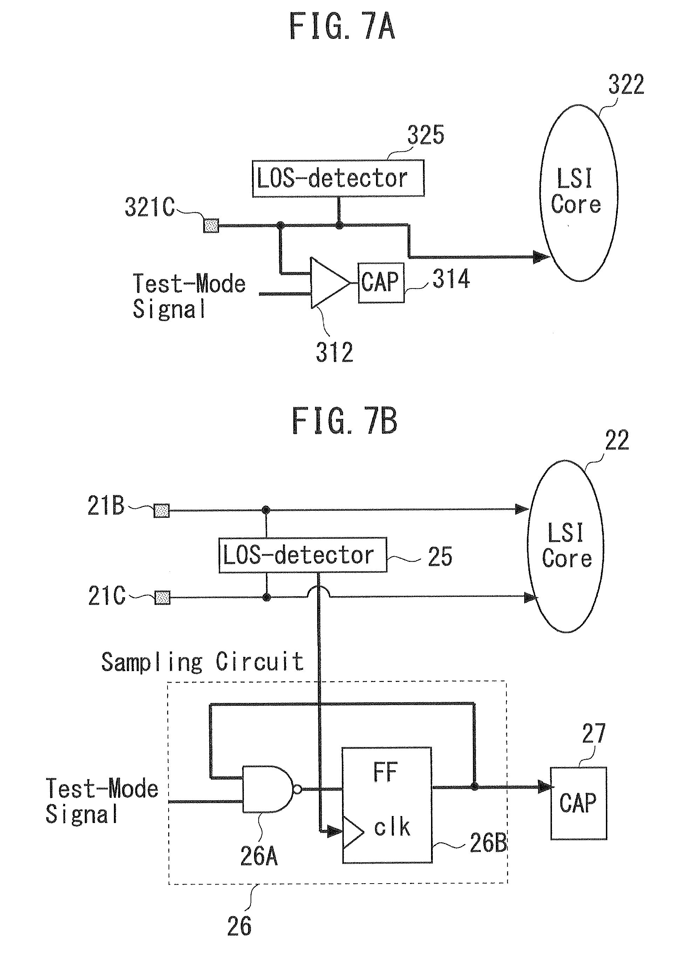

FIG. 7A illustrates a receiving circuit for signals from transmission lines 41 during the conventional boundary scan tests. Conventionally, LOS-detector 324 is inactive during the boundary scan tests, and signals from transmission lines 41, which are, for example, signals transmitted to input port 321C of receiving circuit 321, are input into test receiver 312 provided for the boundary scan tests. During the boundary scan tests, test receiver 312 is turned into an active state by test-mode signals from test control circuit 330 illustrated in FIG. 5A, and receives signals transmitted to the input port and passes the signals to CAP circuit 314. In addition, the structure of test receiver 311 for detecting signals transmitted to input port 321B of receiving circuit 321 and the structure of CAP circuit 313 (FIG. 5A) are the same as those in FIG. 7A, although FIG. 7A does not illustrate the structures thereof.

FIG. 7B illustrates a structure of sampling circuit 26 for processing the determination results in LOS-detector 25. Sampling circuit 26 includes anNANDgate 26Aanda flip-flop 26B. Test-mode signals from test control circuit 30 are input into one input terminal of NAND gate 26A. On the other hand, output signals from flip-flop 26B are input into the other input terminal of NAND gate 26A. Thus, when a test-mode signal is HI (high potential), the output of NAND gate 26A is a signal which is the inverted output of the flip-flop.

Moreover, output signals of NAND gate 26A are input into flip-flop 26B. Additionally, the determination results in LOS-detector 25 are input into the clock terminal of flip--flop 26B. Thus, flip-flop 26B outputs inverted output signals which transit accordingly as the determination results of LOS-detector 25 transit between HI (high potential) and LO (low potential).

For example, in a structure in which flip-flop 26B outputs an input signal at the rising edge of a clock signal (transition from a low potential to a high potential), each time when LOS-detector 25 inputs a rising edge into the clock terminal, flip-flop 26B inverts the output. In addition, in a structure in which flip-flop 26B outputs an input signal at the falling edge of a clock signal (transition from a high potential to a low potential), each time when LOS-detector 25 inputs a falling edge into the clock terminal, flip-flop 26B inverts the output. The outputs of flip-flop 26B are input into CAP circuit 27. CAP circuit 27 converts the input digital signals into bit strings and stores the bit strings in a memory as buffer.

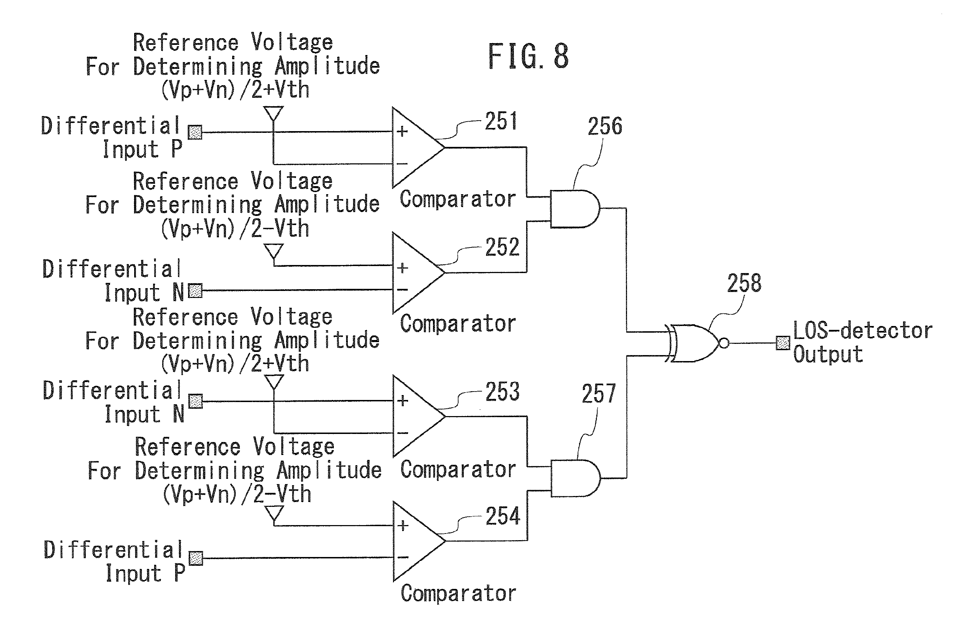

FIG. 8 illustrates a structure of LOS-detector 25 in embodiment 1. LOS-detector 25 includes four comparators 251 to 254, an AND gate 256 for generating logical multiplications of the outputs of comparator 251 and the outputs of comparator 252, an AND gate 257 for generating logical multiplications of the outputs of comparator 253 and the outputs of comparator 254 and an EXOR (EXclusive OR) gate 258 for generating exclusive logical sums of AND gates 256 and 257.

The positive-side (non-inverted) input terminal of comparator 251 is connected with the positive-side terminal 21B for differential input signals. In addition, the negative-side (inverted) input terminal of comparator 251 is connected with the reference voltage for determining amplitudes (Vp+Vn) /2+Vth. Here, Vp is the input voltage of positive-side terminal 21B for differential input signals. Further, Vn is the input voltage of negative-side terminal 21C for differential input signals. Moreover, Vth is a reference value for determining the presence or absence of the differential input signals. Thus, when input voltage Vp of positive-side terminal 21B for differential input signals is more than or equal to a value which is reference value Vth more than the average for positive-side and negative-side input signals for differential signals, comparator 251 outputs HI (high potential). On the other hand, when input voltage Vp of positive-side terminal 21B for differential input signals is not more than or equal to a value which is reference value Vth more than the average for positive-side and negative-side input signals for differentialsignals, comparator251outputsLO (lowpotential) .

Similarly, when input voltage Vn of negative-side terminal 21C for differential input signals is less than or equal to a value which is reference value Vth less than the average for positive-side and negative-side input signals for differential signals, comparator 252 outputs HI (high potential). Thus, when both conditions are satisfied, that is, when input voltage Vp of positive-side terminal 21B for differential input signals is more than the threshold (Vp+Vn) /2+Vth and input voltage Vn of negative-side terminal 21C for differential input signals is less than the threshold (Vp+Vn)/2-Vth, AND gate outputs HI (high potential).

Comparing to comparators 251 and 252, the inputs to comparators 253 and 254 are the ones in which the positive and the negative of differential input signals are inverted. Therefore, when both conditions are satisfied, that is, when input voltage Vn of the negative side of differential input signals is more than the threshold (Vp+Vn)/2+Vth and input voltage Vp of the positive side of differential input signals is less than the threshold (Vp+Vn) /2-Vth, AND gate 257 outputs HI (high potential).

Additionally, when AND gate 256 or AND gate 257 satisfies the condition for HI (high potential), EXOR gate 258 outputs LO (lowpotential). That is, when the differencebetween the positive and the negative of differential input singals is more than or equal to the reference value (2Vth), EXOR gate 258 outputs LO (low potential).

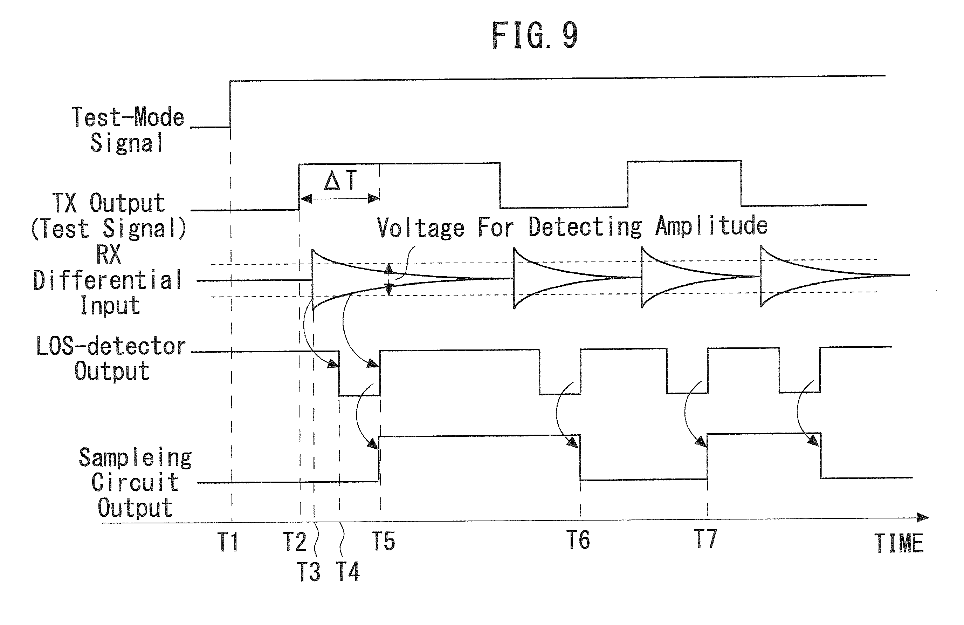

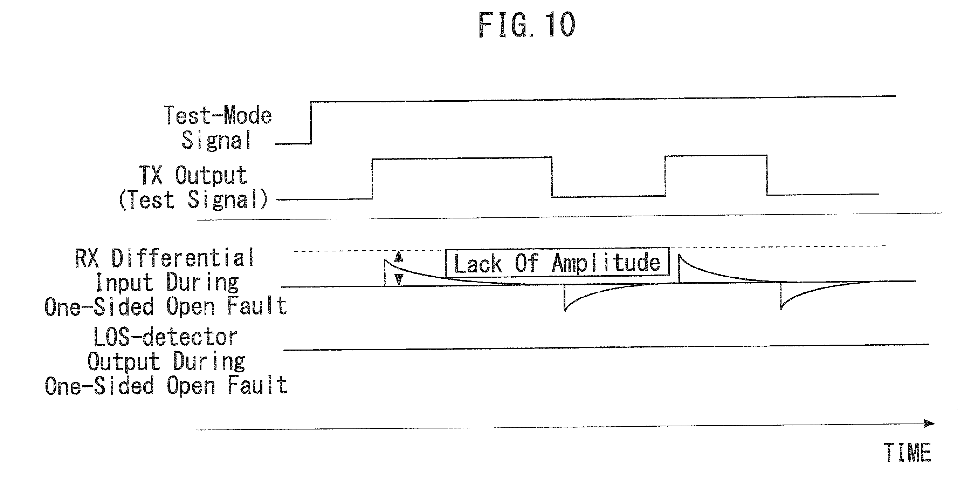

FIG. 9 illustrates a timing chart of the waveforms of each element. FIG. 10 illustrates the fluctuations of test-mode signals in test control circuit 30, test signals from transmission circuit 11, differential input signals in receiving circuit 21, outputs from LOS-detector 25 and outputs from sampling circuit 26 along the axis of time (TIME). In FIG. 9, the test mode signal becomes HI at time T1. Thus, after time T1, NAND gate 26A in sampling circuit 26 inverts the outputs from flip-flop 26B and outputs the inverted outputs. And, the test signal from transmission circuit becomes HI at time T2. And then, at time T3, which is after the time for propagating through transmission lines 41 elapses, the test signal from transmission circuit 11 reaches at input ports 21B and 21C of receiving circuit 21. At time T4, which is after time further elapses, the output of LOS-detector 25 becomes LO. As described with reference to FIG. 8, the output from LOS-detector 25 is maintained to be LO while the amplitudes of differential signals are more than a predetermined reference value. And, when the amplitude of a differential signal is less than the predetermined reference value (for example, time T5), the output from LOS-detector 25 returns to HI. LOS-detector 25 repeats the above operations according to the test signals from transmission circuit 11.

Sampling circuit 26 inverts the output at the rising edge of an output signal from LOS-detector 25. Thus, the output from sampling circuit 26 becomes HI at time T5, and LO at time T6 and HI again at time T7. The rising edge of an output signal from LOS-detector 25 occurs after the delay time Δt elapses from the fluctuations (the rising edge or the falling edge) of the test signal in transmission circuit 11. The delay time Δt is a fixed time which includes the time for the test signal to transmit from transmission circuit 11 to receiving circuit 21, the time constant for the condenser to perform alternating-coupling and the delay time occurred in LOS-detector 25. Therefore, the output signal from sampling circuit 26 is a waveform which is obtained by delaying the test signal transmitted from transmission circuit 11 for the delay time Δt. That is, sampling circuit 26 reproduces test signals transmitted from transmission circuit 11.

FIG. 10 illustrates signals in case of an open fault in which one line of transmission lines 41 is broken. As for differential input signals in receiving circuit 21, the signals for the input port which is connected with the line without an open fault fluctuate in response to the fluctuations of the test signals (TX output) from transmission circuit 11. Thus, the amplitudes of the differential input signals do not reach the threshold for the determination performed by LOS-detector 25. For example, in the circuit in FIG. 8, when transmission line 41 which is connected with positive-side terminal 21B is broken, the outputs from comparator 251 become LO (low potential) or the outputs from comparator 254 become LO (low potential) . Then, both outputs from AND gates 256 and 257 become LO (low potential). Therefore, LOS-detector 25 remains HI. On the other hand, in the circuit in FIG. 8, when the line which is connected with negative-side terminal 21C is broken, the outputs from comparator 252 or the outputs from comparator 253 become LO (low potential). Then, the outputs from AND gates 256 and 257 become LO (low potential).

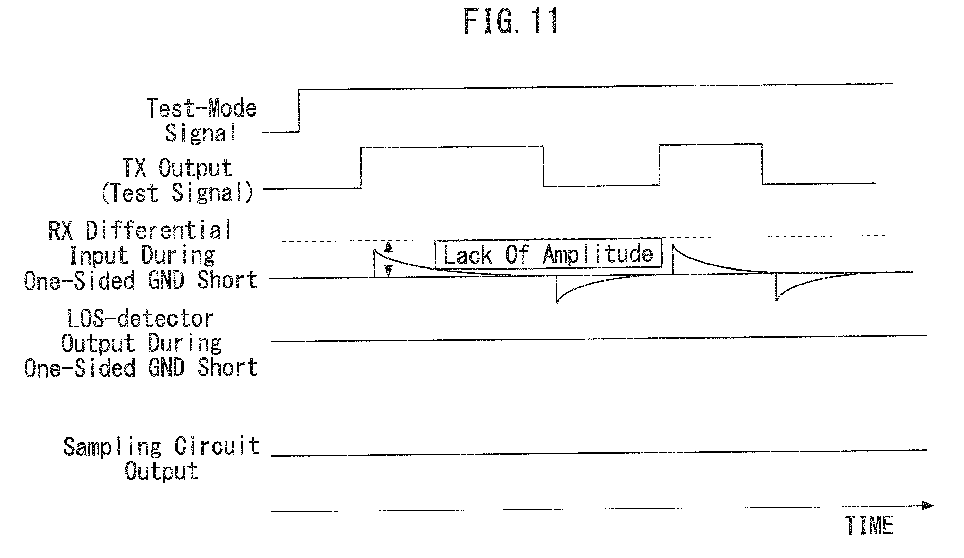

FIG. 11 illustrates signals in case of a short fault in which one line of transmission lines 41 is shorted to the ground potential. Again, in FIG. 11, as for differential input signals in receiving circuit 21, the signals of the input port which is connected with the line without a short fault fluctuate in response to the fluctuations of the test signals (TX output) from transmission circuit 11. Thus, the amplitudes of the differential input signals do not reach the threshold for the determination performed by LOS-detector 25. Consequently, LOS-detector 25 remains HI.

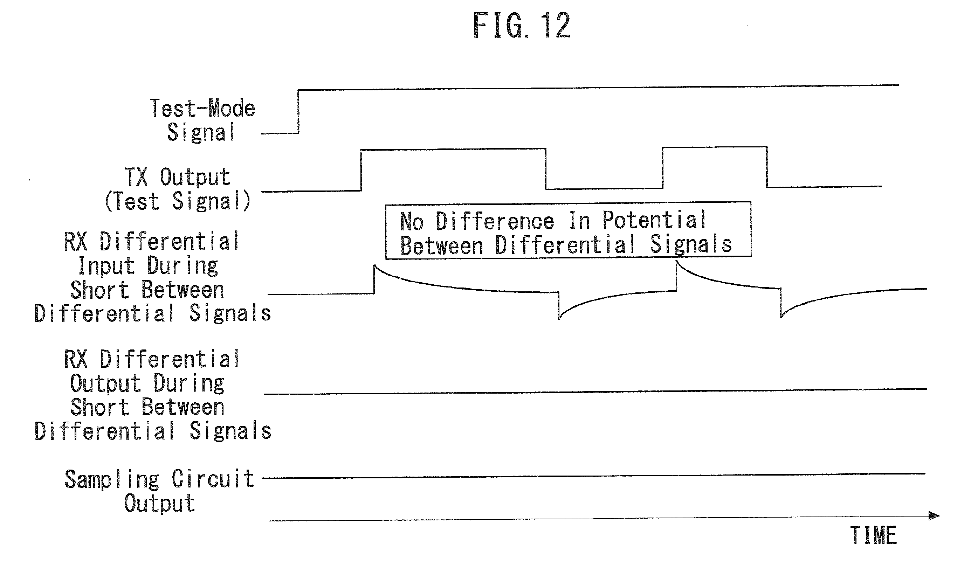

FIG. 12 illustrates signals in case of a short between differential signals in which a short occurs between a pair of lines of transmission lines 41. Since input signals into input ports 21B and 21C of receiving circuit 21 show the same time fluctuations in response to the fluctuations of the test signals (TX output) from transmission circuit 11, no difference is found between the differential signals. Thus, the amplitudes of the differential input signals do not reach the threshold for the determination by LOS-detector 25. Consequently, LOS-detector 25 remains HI.

As described above, according to the test circuit in embodiment 1, LOS-detector 25 outputs a signal of HI or LO according to whether or not the amplitude of differential signals transmitted via alternating-current coupling is more than a predetermined reference value. Therefore, when a test signal from transmission circuit 11 fluctuates more slowly than the time constant of the condenser which achieves alternating-current coupling, the waveforms of differential signals which are transmitted via alternating-current coupling and reach at input ports 12B and 12C of receiving circuit 21 become waveforms which show sharp drops from the peaks. Thus, since LOS-detector 25 determines whether or not the amplitudes of differential signals which reach at input ports 21B and 21C are more than the predetermined reference value, the determination result is inverted after a predetermined time elapses after it reaches the peaks of the differential signals. As a result, the output from LOS-detector 25 is inverted when the delay time Δt elapses after transmission circuit 11 transmits the test signal. Then, the outputs from existing LOS-detector 25 in receiving circuit 22 may be used to reproduce the test signals from transmission circuit 25 by employing sampling circuit 26 in which the outputs are inverted at the rising edges (or falling edges) of LOS-detector 25. Consequently, as in a conventional manner, the boundary scan tests may be performed by using differential transmission lines 41 in which alternating-current couplings are achieved without the use of test receiver 312 dedicated to the boundary scan tests for printed-circuit board 40.

In the structure in embodiment 1, since test receiver 312 is not connected with transmission lines 41 unlike a conventional manner, it may be effective in a circuit such as a high-speed serial interface in which the input impedance of receiving circuit 21 fluctuates moderately. That is, in the structure in embodiment 1, since a structure such as test receiver which is employed for the boundary scan tests is not added to transmission lines 41, the fluctuations of the input impedance of receiving circuit 21 and the input capacitance thereof and the like may be suppressed.

Further, the test receiver is an analog circuit which is provided for the boundary test and the costs for implementing and developing the test receiver may be larger than those for a digital test circuit. That is, the structure in embodiment 1 may reduce the costs.

### [Embodiment 2]

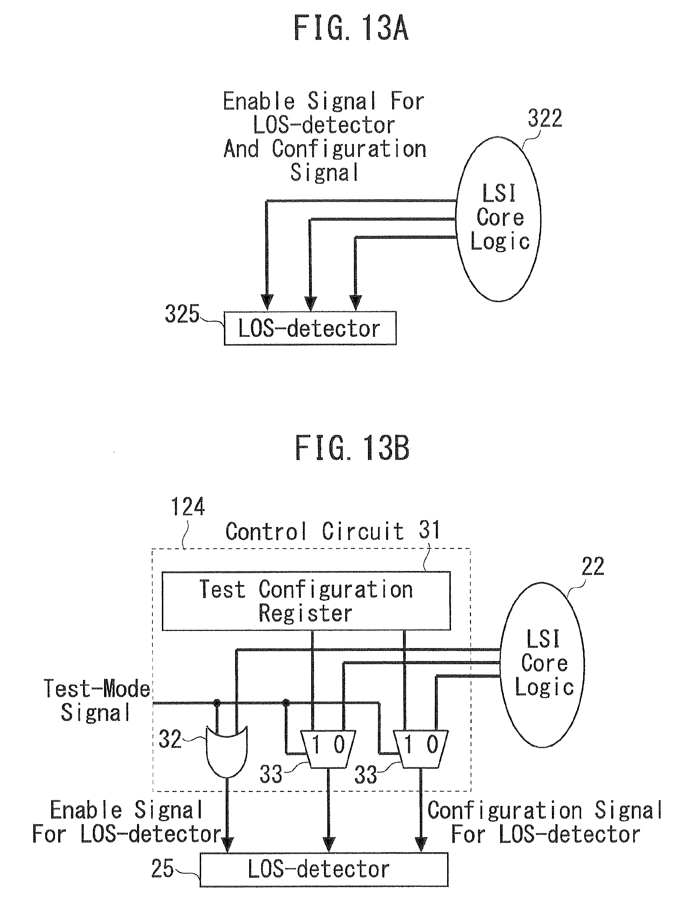

A test circuit in embodiment 2 is described with reference to FIGs. 13A and 13B. In embodiment 1 as described above, test mode signals from test control circuit 30 are used to turn LOS-detector 25 into an active state and then reproduce the test signals from transmission circuit 11 from the test signals transmitted via alternating-current coupling. Embodiment 2 exemplifies a test circuit which achieves a variety of configurations for boundary scan tests in addition to test-mode signals and the like.

FIG. 13A illustrates a structure in regard to the configurations of test conditions for a conventional test circuit. In the conventional test circuit, LSI core logic 322 configures enable signals for LOS-detector 325, and a variety of configuration signals such as a threshold of amplitude detection voltage, for example.

FIG. 13B illustrates a structure of a control circuit 124 in regard to the configurations of a test circuit in embodiment 2. Control circuit 124 in 13B uses, as input, configuration signals for LOS-detector 25 from LSI core logic 22 in addition to test-mode signals which become HI (high potential) during the boundary scan tests to turn LOS-detector 25 into an active state and configure LOS-detector 25 during the boundary scan tests. WhenLSI core logic gives configurations of the threshold of the amplitude detection voltage for LOS-detector 25 and the like to LOS-detector 25 as configuration signals in the normal operation, configurations are not achieved during the boundary scan tests in which LSI core is not turned into an active state. Thus, control circuit 124 holds configuration values for the boundary scan tests in a test configuration register 31. Moreover, selectors 33 and 34 and the like switch according to the test-mode signals between using the configuration values from LSI core logic 22 and using the configuration values in test configuration register 31. Additionally, since the operations of OR gate 21 in FIG. 13B are the same as those of OR gate 24A in FIG. 6B in embodiment 1, the explanations therefor are omitted here.

With the structure as illustrated in FIG. 13B, control circuit 124 may be independent of LSI core logic 22 to give the configuration values for the tests. By employing control circuit 124 according to embodiment 2 in receiving circuit 21 in embodiment 1, test apparatus 50 or test control circuit 30 may be independent of LSI core logic 22 to set configuration values for the boundary scan tests such as the threshold of the amplitude detection voltage for LOS-detector 25 and the like to receiving circuit 21.

### [Variation]

In embodiments 1 and 2 as described above, transmission circuit 11 and receiving circuit 21 are connected each other by transmission lines 41 for transmitting differential signals in which alternating-current couplings are achieved. However, for example, when LOS-detector 25 detect the signals amplitude of a transmission line other than transmission lines 41 for differential signals, a structure similar to the structure in embodiment 1 may be employed to perform the boundary scan tests. That is, the reproduction of the test signals performed by receiving circuit 21 during the boundary scan tests as described above may be applied to not only transmission lines for differential signals but also a normal transmission line in which alternating-current coupling is achieved. Namely, by employing sampling circuit 26 in receiving circuit 21, receiving circuit 21 may receive test signals and the like for the boundary scan tests from a transmission line in which alternating-current coupling is achieved and reproduce the transmitted test signals. Sampling circuit 26 may reproduce a test signal from transmission circuit 11 at the rising edge or the falling edge of a square wave which LOS-detector 25 outputs according to the amplitude of a received signal.

In embodiments 1 and 2 as described above, LOS-detector 25 outputs LO (low potential) when the amplitude of a differential signal is more than the reference value. However, in embodiments 1 and 2, the logical values are not limited to those as described above. For example, the outputs of the determination results from LOS-detector 25, which are LO (low potential) and HI (high potential), may be inverted.

With the receiving apparatus as described above, connection tests using test signals whose speeds are lower than the transmission bands of transmission lines may be achieved without additionally implementing a structure such as a test receiver in the alternating-current coupling transmission line.

## Claims

1. A receiving apparatus for a test signal provided on a transmission line in which alternating-current coupling is achieved, the receiving apparatus for a test signal comprising:
a detection circuit configured to determine whether or not a signal amplitude of the transmission line is more than or equal to a reference value;
a control circuit configured to control the detection circuit to be in an active state during a connection test for the transmission line; and
a reproduction circuit configured to reproduce a transmission waveform from a transmission apparatus on the transmission line on a basis of a determination result of the signal amplitude in the detection circuit when the signal amplitude changes from a value less than the reference value to a value more than the reference value and further the signal amplitude changes from a value more than the reference value to a value less than the reference value.

2. An electronic apparatus comprising:
a transmission apparatus; and
a receiving apparatus for a test signal which is connected with the transmission apparatus via a transmission line in which alternating-current coupling is achieved,
wherein the receiving apparatus for a test signal comprises:
a detection circuit configured to determine whether or not a signal amplitude of the transmission line is more than or equal to a reference value;
a control circuit configured to control the detection circuit to be in an active state during a connection test for the transmission line; and
a reproduction circuit configured to reproduce a transmission waveform from a transmission apparatus on the transmission line on a basis of a determination result of the signal amplitude in the detection circuit when the signal amplitude changes from a value less than the reference value to a value more than the reference value and further the signal amplitude changes from a value more than the reference value to a value less than the reference value.

3. A signal receiving method for a test signal comprising:
controlling a detection circuit to be in an active state during a connection test of a transmission line, the detection circuit determining whether or not a signal amplitude of the transmission line in which alternating-current coupling is achieved is more than or equal to a reference value; and
reproducing a transmission waveform from a transmission apparatus on the transmission line on a basis of a determination result of the signal amplitude in the detection circuit when the signal amplitude changes from a value less than the reference value to a value more than the reference value and further the signal amplitude changes from a value more than the reference value to a value less than the reference value.
